# EUROPEAN PATENT SPECIFICATION

(11) **EP 4 447 119 B1**
(45) Date of publication and mention of the grant of the patent: **10.06.2026**
(21) Application number: 23167846.7
(22) Date of filing: 13.04.2023
(51) Int. Cl.: H10H 29/01, H10H 20/01, H10H 29/14, H10H 29/80, H10H 29/85, H10H 20/819, H10H 20/825, H10H 20/831, H10H 29/45, H10H 29/854, H10H 20/812, H10H 20/821, H01L 25/16

(54) **METHOD FOR MANUFACTURING A LED ARRAY, CORRESPONDING LED ARRAY AND DEVICES COMPRISING THE SAME**
HERSTELLUNGSVERFAHREN EINER LED-ANORDNUNG, ENTSPRECHENDE LED-ANORDNUNG UND VORRICHTUNGEN DAMIT
PROCÉDÉ DE FABRICATION D'UN RÉSEAU DE DELS, RÉSEAU DE DELS CORRESPONDANT ET DISPOSITIFS LE COMPRENANT

(43) Date of publication of application: 16.10.2024
(73) Proprietor: Polar Light Technologies AB, 583 26 Linköping (SE)
(72) Inventor: Hsu, Chih-Wei, 58666 Linköping (SE); Le, Son Phuong, 59558 Mantorp (SE); Martinovic, Ivan, 73451 Kolbäck (SE); Svensson, Christer, 58226 Linköping (SE); Holtz, Per Olof, 58244 Linköping (SE)
(74) Representative: Bergenstråhle & Partners AB

(56) References cited:
- WO-A1-2018/057041
- DE-A1- 102018 105 786
- US-A1- 2018 076 363
- US-A1- 2020 035 860
- US-A1- 2020 373 461

## Description

### TECHNICAL FIELD

The present invention relates generally to light emitting structures, more specifically to light-emitting diode (LED) array precursors, manufacturing methods thereof, LED arrays and devices comprising the same. In particular, the present invention concerns a manufacturing method which is more homogeneous, resulting in a better pixel yield, having an improved hybridization process and reduced number of processing steps and LED arrays precursors, LED arrays and devices comprising the same with an improved luminosity, improved control the direction of polarization of the emitted light, high energy efficiency, high brightness, and compact dimension.

### BACKGROUND

LEDs are typically semiconductor-based light sources that emit light when a current is applied. LED arrays are single LED chips comprising multiple emitters. Each emitter has two connections, a cathode and an anode, which allows each emitter to be individually addressable. Due to their advantageous characteristics, such as long lifetime, low power consumption, small size, fast switching times and shock resistance, LEDs are applied in a wide range of applications from everyday consumer products such as lamps and displays to highly specified medical and military applications. Conventional inorganic semiconductor LEDs, and especially group III-based material systems are popular choices for applications in solid-state lighting and backlighting for liquid-crystal displays (LCDs). For more advanced applications micro-LED are commonly used as they have a higher brightness and emitter density. Typically, micro-LEDs have an arrays size of 100 x 100 emitters or less with emitters having a size about 100 µm x 100 µm or less.

Novel applications of micro-LED arrays, especially in augmented reality (AR) and virtual reality (VR), demand an increasing number of emitters and at the same time a reduced size of the arrays, meaning an improved pixel density. Further improved characteristics such as energy efficiency, brightness and contrast ratio are especially desirable for applications where the light from the emitter should be visible in contrast to daylight, as for example in AR smart glasses and in heads-up displays.

Conventional manufacturing of such LED arrays requires several complex manufacturing steps. This makes the cost- and time-effective production in large quantities difficult if at the same time requirements on pixel control and yield need to be met. To archive improvements in characteristics of micro-LED arrays and their manufacturing as listed above, the design, fabrication methods and integration of micro-LEDs need to be adapted.

Currently two fabrication strategies are employed to produce micro-LEDs: the conventional manufacturing method is corresponding to the one used for normal sized LEDs, in which the arrays are assembled by picking and placing individual components, and the fabrication route is based on monolithic integration. An advantage of the conventional fabrication method is that LEDs with different dominant colors (emission wavelength) can be assembled within one array even if they were grown at different conditions and/or on different substrates. Further, faulty components can be replaced and thereby a high final yield of the array can be achieved. On the other hand, picking and placing components leads to an increased production time and limits resolution and array size. By applying a monolithic integration fabrication strategy multiple emitters and also passive elements are formed on top of a single substrate, wherein the single emitters are intentionally spaced across the array in specific patterns, and which are individually addressable.

The elements on the substrate are typically formed by vacuum deposition techniques such as chemical vapor deposition (CVD). Especially metalorganic chemical vapor deposition (MOCVD) methods are used to grow complex semiconductor multilayer structures for LED applications. The formation of semiconductor multilayers for LED production is well described in the known art.

The interest for group-III nitrides has grown rapidly during the last years. One reason is the semiconducting properties of group-III nitrides that may be utilized in LEDs. The application of group-III nitride based micro-LED is discussed in Matthew S. Wong et al 2020 ECS J. Solid State Sci. Technol. 9 015012.

GB 2575311 discloses a monolithic LED array and a precursor thereto based on group-III nitride structures. The primary and secondary electric contact are formed on opposite side of the first semiconductor layer of the LED array precursor. Thereby, the solution disclosed in GB 2575311, allows electrical contact formation only after the substrate was removed from the precursor. This has the clear disadvantage of requiring additional processing steps. Further, the electrical contacts cannot easily be mechanically stabilized as they are located on the light-emitting side of the front plane. The positioning of the secondary electrical contact on the light-emission side also reduces the total area available for light emission or positioning of other optical elements on that side.

The preparation of a group III-nitride structure in the shape of a structural elongated pyramid with the pyramid providing preferred locations for quantum dots at the apex of the pyramid is disclosed in SE537434C2. There, the quantum dots serve as light sources with sharp emission lines. For elongated pyramids, the emission from the ridge of theelongated pyramids is linearly polarized to a high degree. SE537434C2 does not disclose how such or similar structures can efficiently be implemented into a monolithic fabrication method or how to obtain novel LED arrays with improved emission properties and generation of polarized light.

US 2020/0373461 A1 discloses an emitter having a substrate and a mesa made of a first semiconductor material. Connection pads are provided on electrical contacts of a part with mesas. A control circuit is brought in contact with the connection pads.

WO 2018/057041 A1 relates to a monolithic multi-color light emitting pixel. A BGA (Ball Grid Array) is described in context of an interposer that may be an intervening substrate used to bridge a first substrate to a second substrate. The first substrate may be an integrated circuit die, such as a multi-color LED pixel. The second substrate may be, for instance, a memory module, a computer motherboard, backplane, or another integrated circuit die. The interposer may couple an integrated circuit die to the BGA that can subsequently be coupled to the second substrate.

DE 10 2018 105786 A1 discloses an optoelectronic multi-pixel chip and method for producing it. A first semiconductor region extends continuously across the pixels. A second semiconductor region is structured on the pixels. An active zone for generating the light is disposed between the first and second semiconductor regions. A first contact is provided for making electrical contact with the first semiconductor region, and a second contact is provided for making electrical contact with the second semiconductor region.

US 2018/0076363 A1 discloses a monolithic image chip based on first and second nanowires. The first nanowire includes a first active region having a first band gap and a second active region having a second band gap. Each subpixel of the chip may be accessed independently using a combination of contact structures.

US 2020/0035860 A1 describes a light emitting element that includes a first conductivity type semiconductor rod having a plurality of side surfaces arranged to form a polygonal column shape; an active layer formed of a semiconductor and covering the side surfaces; and a second conductive type semiconductor layer covering the active layer. The active layer includes a plurality of well layers.

### SUMMARY OF INVENTION

An object of the present invention is to overcome at least some of the problems and disadvantages mentioned in the prior art on LED arrays and structures applicable for use therein.

As used herein, the term "LED structure" may refer for the extent of this application to the single structural assembly allowing for the light emission when connected to secondary electrical contacts or electrical circuits to drive such light emission, e.g. a microstructure. The term "LED array precursor" may refer for the extent of this application to a LED array without defined secondary electrical contacts or electrical circuits to drive light emission. The term "epi surface side" may refer for the extent of this application as a side on which further material layers are deposited onto.

According to a first aspect of the invention, there is provided a method of forming a light-emitting diode (LED) array in accordance with the appended claim 1.

According to a second aspect of the invention, there is provided a LED array in accordance with the appended claim 11.

According to a further aspect of the invention, there is provided, in accordance with the appended claim 15, a display device, a communication device, an optoelectronic device, an interconnect device, a cryptography device, a lighting device or illumination device comprising the LED array according to the second aspect. By utilizing the LED array according to the second aspect, the devices can be small in size, have a high luminosity, low energy consumption, and the devices may require less optical elements as the positioning and connecting of the microstructures can correct for different optical effects.

In view of the above the present invention provides a manufacturing method, which is more homogeneous, resulting in a better pixel yield, having an improved hybridization process and reduced number of processing steps, and a LED array precursor, LED array and devices comprising the same with an improved luminosity, high energy efficiency, high brightness, and compact dimensions.

Further objectives and features of the present invention will appear from the following detailed description of embodiments of the invention. Each aspect so defined may be combined with any other aspect or aspects of the invention, provided they still fall within the scope of the appended claims, unless clearly indicated to the contrary. Any feature indicated as being preferred or advantageous may be combined with any other feature or features indicated as being preferred or advantageous, provided their combination still falls within the scope of the appended claims. Especially different microstructures, active layers comprising quantum structures, and architectures of the LED array precursor and the backplane may be combined freely.

### BRIEF DESCRIPTION OF THE DRAWINGS

The invention will now be described, by way of example, with reference to the accompanying drawings, in which:
**Figure 1a** schematically illustrates an example of a LED array precursor with both the anode and the cathode electrical contacts being positioned on the epi surface side of the substrate. **Figure 1b** schematically illustrates another embodiment of a LED array precursor with anode and cathode electrical contacts formed at least partially comprising areas in which nanostructures are positioned.
**Figures 2a****-c** schematically illustrate a backplane with metal contact bumps to contact the respective electrode metal contact of the LED array precursor.
**Figure 3** schematically illustrates another embodiment of a LED array precursor with a further masking layer which allows for selectively depositing electrode contact material in the further apertures which at least partly comprise microstructures.
**Figure 4** schematically illustrates an example of forming electrical contacts between a LED array precursor and a backplane by chemically, physically and/or mechanically bonding electrical contacts via metal bumps to bonding pads of the backplane. The direction of light emission is also indicated.
**Figure 5** schematically illustrates an example of a LED array comprising a LED array precursor with both anode and the cathode electrical contacts in electrical contact with a backplane and wherein gaps between a LED array precursor and a backplane are filled with a filler material.
**Figures 6a****-i** schematically illustrate cross sections of different examples of microstructures which may be used in a LED array.
**Figures 7a****-h** schematically illustrate top views of different examples of microstructures which may be used in a LED array.
**Figures 8 a-f** schematically illustrate top views of different examples of patterns of apertures and electrode contact material.

### DETAILED DESCRIPTION

The main aspects of the invention are defined by the appended independent claims. Advantageous, further embodiments of the invention are set forth in the appended dependent claims and in the following description and drawings.

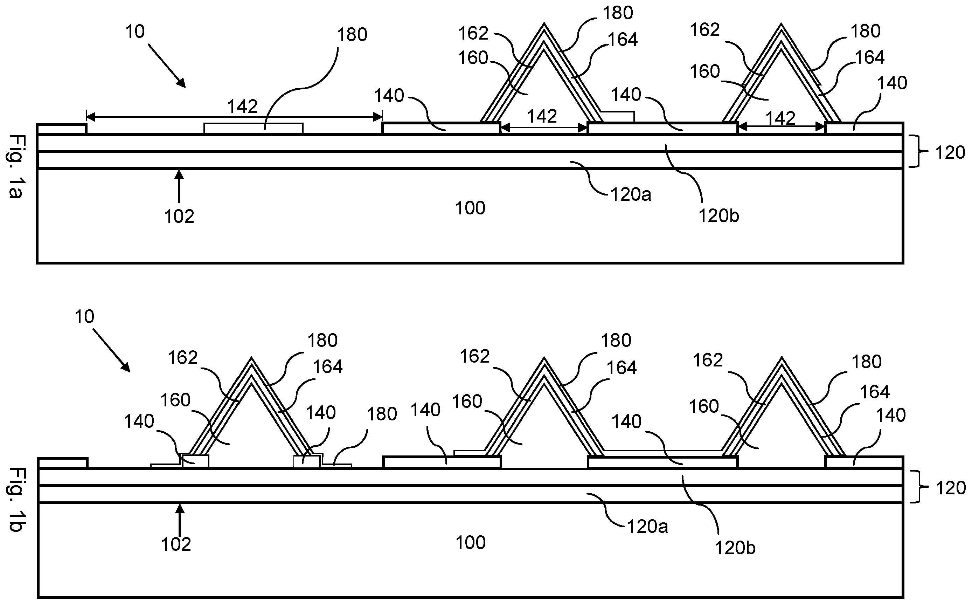

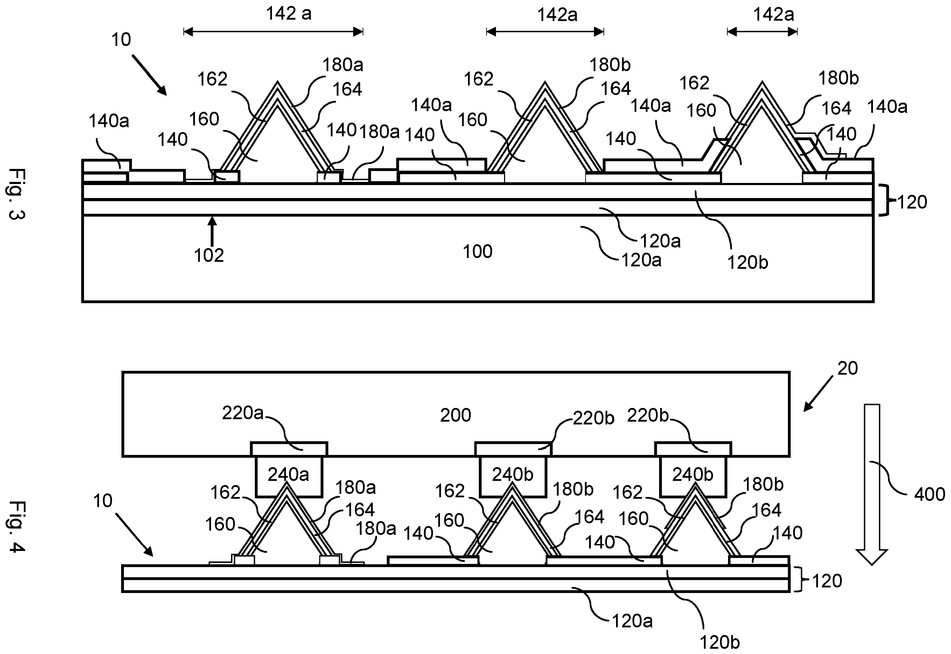

According to first example embodiments, not forming part of the invention as claimed but useful for understanding its context, there is provided a method for forming a LED array precursor 10 such as exemplary shown in Figures 1 and 3. Said method involves several numbered steps which can be performed simultaneously or concurrently. Single steps may be repeated several times and the order of the steps may be altered in various combinations leading to meaningful deposition of materials. Before, between and after the explicitly mentioned steps, may several cleaning, drying and/or heating steps occur. Such additional preparatory steps are well known in the art and may include cleaning with organic solvents or inorganic acids to remove contaminants, e.g. excess material from previous steps or contaminants.

Step (i) is providing a substrate 100. Further deposition of materials is performed on the epi surface 102 of the substrate 100. Step (ii) is forming one or more first layers 120 on the epi surface side 102 of the substrate 100, wherein the one or more first layers 120 at least comprise the first semiconductor layer 120b. Further, buffer layers 120a stacked between the substrate and the first semiconductor layer 120b may be formed. Step (iii) involves selectively masking said one or more first layers 120 by thereon depositing one or more masking layers 140. The one or more masking layers 140 may be selectively deposited or patterned by optical lithography methods known in the art. Excess material of the one or more masking layer 140 can be removed in additional cleaning steps, e.g., rising with deionized water. The unmask portions of said one or more first layers 120 form a plurality of apertures 142. Step (iv) is forming microstructures 160 within at least part of the plurality of apertures 142, wherein the microstructures 160 are in physical and electrical contact with the first semiconductor layers 120. Optional step (v) is forming one or more active layers 162 at least partly covering the microstructures 160. The active layers 162 may be deposited only on parts of the microstructures 160. Optional step (vi) is forming a second semiconductor layer 164 at least partly covering the microstructures 160 and/or the one or more active layers 162. Step (vii) is forming both anode and cathode electrical contacts 180a, b on the epi surface side 102 of the substrate 100. To form both anode and cathode electrical contacts 180a, b electrode contact material 180 may be deposited into apertures 142 which are empty, i.e. an aperture142 without a microstructure 160 filled, i.e. an aperture 142 comprising a microstructure 160, or over an area covering several apertures 142 both filled and empty. Thereby allowing to form an electrical connection between the LED array precursor 10 with electrical contacts within a LED array from one side of the LED array precursor 10 only. This has the advantage of reduced number of processing steps when integrating the LED array precursor 10 into a LED array. Further, the area on the light emission side, opposite to the epi surface side 102, of the LED array precursor 10 is not covered with electrical contacts which leaves a greater area available for light emission or positioning of other optical elements on that side. Additionally, by positioning anode and cathode electrical contacts 180a, b on the epi surface side 102, both electrical contacts can be mechanically stabilized after contacting with a backplane 20.

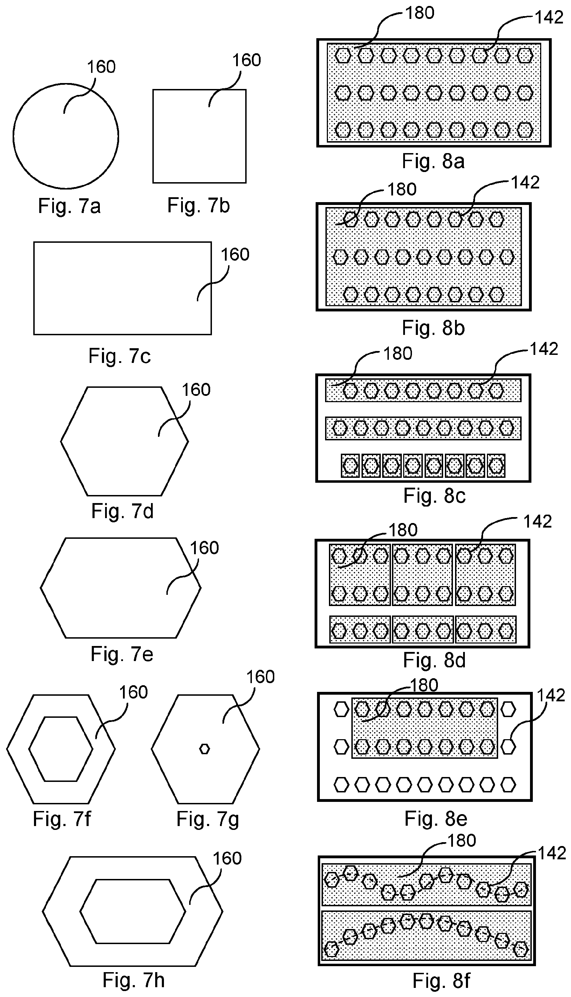

In some embodiments step (vii) comprises the substeps of (i) depositing one or more further masking layer 140a on the epi surface side 102. The one or more further masking layer 140a may cover any combination of underlying previously deposited structures, such as the first layers 120, the masking layer 140, the microstructures 160, the active layers 162, the second semiconductor layer 164. The masking layer 140a may cover underlying structures in part, also asymmetrically, or completely. Substep (ii) involves patterning the further masking layer 140a, the skilled person may select any suitable lithography method known in the art for that purpose, and by that selectively removing a plurality of portions from the further masking layer 140a to create further apertures 142a. At least part of the so formed further apertures 142a comprise areas with underlying microstructures 160. These microstructures 160 may be themselves covered by other layers, such as the masking layer 140, the active layers 162, the second semiconductor layer. Excess material of the further masking layer 140a can be removed in additional cleaning steps, e.g., rinsing with deionized water. Substep (ii) involves depositing an electrode contact material 180 onto the patterned masking layer 140a. The electrode contact material 180 may be different for the formation of the cathode metal contact 180a and the anode metal contact 180b. Optional substep (iv) involves removing at least parts of the excess electrode contact material 180 and/or the masking layer 140a. The substeps of the embodiments may be repeated for the formation of the anode and cathode metal contacts 180a, b, respectively. The substeps of the embodiments may be repeated several times to generate several patterns of apertures 142, 142a and electrode contact material 180 may be used within a LED array precursor 10. Examples of such patterns are explained in relation to Figures 8a-f. The advantage of positioning both the anode and cathode metal contacts 180a, b on the electronically isolated LEDs comprising microstructures 160 and active layers 162 is that depending on the integration circuit each LED or group of LEDs can be individually addressed and thereby the light emission from the individual LEDs can be controlled separately. Further, by contacting the LEDs from the epi surface side 102 only, shorter electrical connection paths can be accomplished.

Preferably, the substrate 100 is made of a material selected from the group consisting of SiC, Al₂O₃ (sapphire), Si, GaN, GaN on Si, GaN on sapphire, SiO₂, graphene, GaO. Preferably, the material of the first and second semiconductor layers (120b, 164), the microstructures 160 and the active layers 162 comprise group III-nitrides. Preferably, the buffer layers 120b are selected from the group consisting of SiC, sapphire, Si, GaN, GaN on Si, GaN on sapphire, GaN, AIN, InN and their ternary and quaternary compounds.

Preferably, the microstructures 160 are pyramids, elongated pyramids, elongated truncated pyramids, platelets, nanowires, nanowires with a pyramidal top, etched structures or a combination thereof. Microstructures 160 are advantageous building-blocks for LED structures as they can be selectively grown in the apertures 142, 142a. Thereby additional etching step can be avoided, and the overall number of processing steps is maintained low.

Preferably, the active layer 162 comprises one or more quantum structures, such as quantum wells, quantum dots, quantum wires or a combination thereof. Preferably, the quantum structures comprise GaN, AIN, InN and/or their ternary and quaternary compounds. The quantum structures may serve as sources for polarized light emission and thereby resulting devices using the LED array precursor may not require polarization filters implemented between the emitter and display.

Preferably, the underlying LED structure allows for light emission in the visible range, i.e. 380-750 nm, and/or UV range, i.e. 100-380 nm. Combinations of microstructures 160 and active layers 162 may be used to generate light emission of the LED structures at several different dominant wavelengths. The dominant wavelength of the LED structures may differ for the different LED structures within the LED array precursor 10. Preferably, the LED array precursor 10 exhibits LED structures in several different dominant wavelength regimes, e.g. red, green, blue, yellow, white and UV.

In some embodiments, the method according to the first example embodiments comprises a further step of at least partially removing the substrate 100 or partially removing the substrate 100 and the first layers 120 from the LED array precursor 10. Through the removal, the light emission of the single LED structures in the light extraction direction 400 is facilitated when connecting the LED array precursor 10 to associated secondary electrical contacts or electrical circuits to drive the light emission.

In some example embodiments relating to the present invention as claimed, the method according to the first example embodiments comprises a further step of forming electrical contact between at least part of anode and cathode electrical contacts 180a, b of the LED array precursor 10 with a backplane 20 by chemically, physically and/or mechanically bonding the electrical contact material 180 with a corresponding bonding pad 220 of the backplane 20 and thereby bringing both the anode and cathode contacts 180a, b in electrical contact with secondary electrical contacts of the backplane 20. The electrical contact between the LED array precursor 10 and the backplane 20 is formed via metal bumps 240. Formation of the electrical contact via metal bumps 240 has the advantage of evening out height differences among LED structures on the LED array precursor 10 and thereby strain within the resulting LED array is minimized.

In some embodiments, the method according to the first example embodiments comprises a further step, wherein the gap between the LED array precursor 10 and the backplane 20 is filled with a filler material 300. The filler material 300 is used to redistribute the thermo-mechanical stress created by the coefficient of thermal expansion (CTE) mismatch between the different materials of the components of the LED array precursor 10 and the backplane 20. Further, the filler material 300 protects from moisture entering the components.

According to second example embodiments, there is provided a LED array precursor 10 obtainable according to the first aspect.

According to third example embodiments, not forming part of the invention as claimed but useful for understanding its context, there is provided a LED array precursor 10 comprising optionally a substrate 100; one or more first layers 120, wherein the first layers comprise at least a first semiconductor layer 120b and wherein further one or more first layers 120, if any, are buffer layers 120a; optionally a masking layer 140 at least partially covering said one or more first layers 1, wherein the masking layer 140 comprises a plurality of apertures 142; microstructures 160 on said first semiconductor layer 120b within at least parts of the apertures 142 of the masking layer 140; optionally an active layer 162 at least partly covering the microstructures 160; optionally a second semiconductor layer 164 at least partly covering the microstructures 160 and/or the active layer 140, both anode and cathode electrical contacts 180a, b, wherein both the anode and the cathode electrical contacts 180a, b are formed on the epi surface side.

According to fourth example embodiments, there is provided a LED array comprising a LED array precursor 10 according to the second or third example embodiments.

According to further example embodiments, there is provided a display device, a communication device, an optoelectronic device, an interconnect device, a cryptography device, a lighting device or illumination device comprising the LED array according to the fourth example embodiments and/or a LED array precursor 10 according to any of second or third example embodiments. By utilizing the LED array according to the fourth example embodiments and/or a LED array precursor 10 according to any of the second or third example embodiments, the
devices can be small in size, have a high luminosity, low energy consumption, and the devices may require less optical elements as the positioning and connecting of the microstructures can correct for different optical effects.

Figures 1a and 1b schematically illustrate cross sections through a LED array precursor 10, which is based on light emission from electronically isolated LEDs comprising microstructures 160 and active layers 162. The LED array precursor may be monolithic. The single LEDs of the LED array precursor may be grouped into different sub-arrays which are capable of emitting light at different dominant wavelengths. Other specific positioning and/or grouping of LEDs may occur as will be described in Figures 8a to 8f.

As shown in Figures 1a and 1b, the LED array precursor is formed on a substrate 100. The substrate has an epi surface side 102. Suitable materials for the substrate 100 include SiC, sapphire, Si, GaN, GaN on Si, GaN on sapphire, GaN on SiC, SiO₂, and graphene, GaO. As used herein, any reference to a species by its constituent components includes all available stoichiometries thereof. Thus, for example, AlGaN includes all alloys thereof, such as AlₓGa₍₁₋ₓ₎N wherein x does not equal 1 or 0. Preferred stoichiometries will vary depending on the function of the specific layer. The substrate 100 may be any known n-type substrate, semi-insulating or insulating substrate or any other suitable substrate which is well known in the art. Preferably, the substrate 100 has a (0001) orientation.

On the epi surface side 102 of the substrate 100 first layers 120 are formed. The first layers 120 are in direct physical contact with the substrate 100 and the layers comprising the first layers 120 are in direct physical contact with the layers stacked above and below, where applicable. The first layers 120 may be continuous, discontinuous and/or not completely covering the substrate 100. The first layers may be epitaxial layers. The first layers 120 comprise at least one first semiconductor layer 120b. The first semiconductor layer 120b may comprise group III-nitrides, such as GaN, AIN, InN and their ternary and quaternary compounds. The group III-nitrides of the semiconductor layer 120b may be n-doped. The n-doping may be achieved by using dopants such as Si, C, Ge and their respective precursors. The dopants may be in a range from 10e¹⁵ to 10e²¹ cm⁻³, preferably 5e¹⁸ cm⁻³. The first semiconductor layer 120b may have a thickness of 1 µm to 3 µm, more preferably a thickness of 2 µm. Preferably, the first semiconductor layer 120b is (0001) oriented. The first layers 120 may comprise further additional semiconductor layers 120b.

Further, the first layers 120 may comprise one or more buffer layers 120a which are stacked between the substrate 100 and the first semiconductor layer 120b or between further semiconductors layers 120b of the first layers 120. The one or further buffer layers 120b may comprise SiC, sapphire, Si, GaN, GaN on Si, GaN on sapphire, GaN, AIN, InN and their ternary and quaternary compounds. The buffer layers 120a may have a thickness ranging from 2 nm to 3 µm, preferably 2 µm.

The first layers 120 are at least partially covered by a masking layer 140 on the side opposite to the substrate 100. The masking layer 140 may be continuous, discontinuous and/or not completely covering the first layers 120. The masking layer 140 may be a lithographically patterned layer. The masking layer 140 may have a thickness ranging from 5 nm to 200 nm, preferably 50 nm. The material of the masking layer 140 may comprise any of SiO₂, SiNₓ and /or Al₂O₃. The masking layer 140 may be electrically insulating. The masking layer 140 may be an amorphous layer. The masking layer 140 may be deposited ex-situ with standard deposition techniques known in the art such as low-pressure chemical vapor deposition (LPCVD) or plasma enhanced chemical vapor deposition (PECVD). Alternatively, the masking layer 140 may be deposited in suitable reaction chambers, such as CVD reactors.

The masking layer 140 comprises a plurality of apertures 142. The plurality of apertures 142 may be formed by selectively removing parts of a masking layer 140. The removal of masking layer 140 to form the plurality of apertures 142 may be performed by UV lithography and selectively etching parts of the masking layer by e.g., plasma etching, wet etching or reactive ion etching. Alternatively, the masking layer 140 may be area-selectively deposited by techniques such as laser-CVD or photo-CVD. The apertures 142 may vary in size. Preferably the diameter of the apertures 142 is 50 nm to 30 µm, more preferably the diameter of the apertures 142 is 1 µm to 3 µm. The preferred center-to-center distance between the apertures 142 is from 1 µm to 10 µm. The apertures 142 may have a circular shape, or a mainly circular shape, for example oval. The apertures may have specific sizes depending on the pattern of microstructures 160 to be grown in them. Other shapes of the aperture 142 may also be used to obtain other growth conditions for the microstructures 160 and/or the QS in the active layer 162. The growth conditions and the growth mode have major impact on properties such as homogeneity, luminous efficiency, internal efficiency, and light extraction efficiency (LEE).

Within the apertures 142 there may be directly deposited an electrode metal contact 180 as illustrated in Figure 1a. The electrode metal contact may serve as a cathode metal contact 180a or an anode metal contact 180b. Examples of material for electrode metal contacts 180 are Ti/Au, WTiAu, and Al for the cathode contact material 180a and AINi/Au and ITO (Indium tin oxide) as anode electrode contact material 180b. The same or different materials may be used for the formation of the cathode metal contact 180a and the anode metal contact 180b. Any electrode material known in the art may be used as electrode metal contact 180. Electrode metal contact material 180 may be deposited by techniques such as thermal evaporation or electron-beam evaporation.

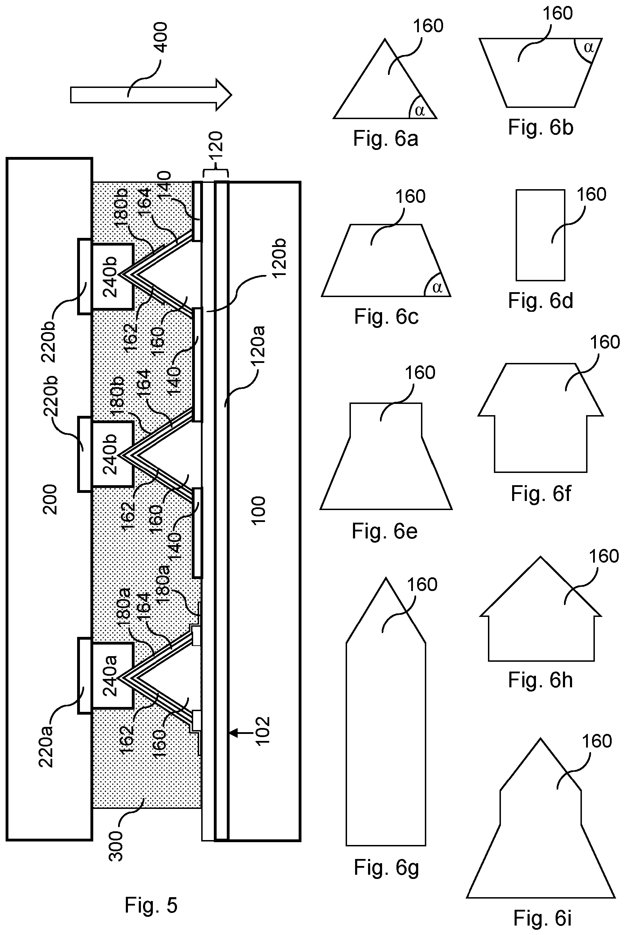

Within at least parts of the apertures 142 of the masking layer 140 microstructures 160 are grown. The microstructures 160 may be grown by selective area growth (SAG). By using SAG for the manufacturing of the microstructures 160 in the electrically isolated apertures 142 no additional etching step is necessary to define the microstructures, contrary to traditional methods. This is due to the growth conditions favoring growth of the microstructures 160 on the first layers 120, which are not covered by the masking layer 140. The microstructures may be n-doped microstructures. The n-doping may be achieved by using dopants such as Si, C, Ge and their respective precursors. The dopants may be in a range from 10e¹⁵ to 10e²¹ cm⁻³, preferably 5e¹⁸ cm⁻³. A selection of suitable types of microstructures are shown in Figures 6 and 7 and are described later. The microstructures may be grown by metalorganic chemical vapor deposition (MOCVD), especially low-pressure horizontal hot-wall MOCVD may be employed. Different types of microstructures 160 may be grown in different apertures 142 within a LED array precursor 10. Different subarrays may be associated with a specific type of microstructure 160 to emit light at a certain dominant wavelength. Several microstructures 160 may be grown in a single aperture 142, e.g., several nanowires. The microstructures 160 may have different growth times to obtain microstructures 160 which emit light at different dominant wavelengths.

The microstructures 160 may at least partly be covered by one or more optically active layer 162. Optically active layer 162 comprising one or more quantum structures (QS), such as quantum wells, quantum dots, quantum wires or a combination thereof is grown on top of the microstructures 160. The optimal positioning of QS within the active layer 162 is dependent on the underlying microstructure 160. For microstructures 160, being pyramidal microstructures, the QS may either be positioned on the pyramid facets or on top of either sharp or truncated pyramids. Further, positioning of QS on edges of facets of microstructures 160 may be advantageous, e.g. when the microstructure 160 is a one dimensional structures. The confinement effects prevailing in the QS will reduce the negative effects of the quantum confined Stark effect (QCSE). The QCSE is well described in the known literature. The QCSE in the QS can be further reduced due to the non- or semi-polar facets of the microstructure 160. Thereby the light extraction efficiency of the QS is increased. The QS may comprise GaN, AIN, InN and their ternary and quaternary compounds. The light emission of the QS is typically intense and exhibiting a narrow bandwidth due to the confinement of the QS, typically less than a few millielectronvolt (meV). Further, the approach of obtaining QS on selected sites of the microstructures 160 allows highly controlled polarization direction of the light emitted from the active later 162. The microstructures 160 and the optically active elements 162 may be covered by different electrically active layers 162 depending on whether the microstructure 160 is used as anode or cathode. Further, the active layer 162 may be adapted depending on the underlying microstructure or depending on a specific subarray of microstructures 160.

A second semiconductor layer 164 may be at least partly covering the microstructures 160 and/ or the active layers 162 covering the microstructures 160. The second semiconductor layer 164 may comprise group III-nitrides, such as GaN. The group III-nitrides of the second semiconductor layer 164 may be p-doped. The p-doping may be achieved by using dopants such as Mg and their respective precursors. The dopants may be in a range from 10e¹⁵ to 10e²¹ cm⁻³, preferably 5e¹⁸ cm⁻³ to 5e¹⁹ cm⁻³. The second semiconductor layer may have a thickness ranging from 1 nm to 3000 nm (3 µm), preferably 300 nm.

The second semiconductor layer 164 may at least partly be covered by an electrode metal contact 180. Through the electrode metal contact 180 electrical contacts for a single LED or a group of LEDs of the LED array precursor 10 is formed to individually address the light emission though an associated circuit. The electrode metal contact 180 serves thereby to connect the first layers 120, if deposited directly into an aperture 142 as described previously, and/ or LEDs of the LED array precursor 10 with secondary electrical contacts of a backplane 20. The second electrical contacts may be metal bumps 240. The electrode metal contact 180 may extend over the entire microstructure 160, which may be covered by an active layer 160 and/ or a second semiconductor layer 164, or parts of it. The electrode metal contact 180 may extend over several microstructures 160, which may be covered by an active layer 160 and/ or a second semiconductor layer 164, or parts of it, thereby connecting the electrical contacts on one or both electrode sides. The coverage of the electrode metal contact 180 may not be symmetric on all sides of the microstructure 160. The electrode metal contact 180 may be overgrown on parts of the microstructure 160, which may be covered by an active layer 162 and/or a second semiconductor layer 164, as shown for the left microstructure in Figure 1a and in the middle microstructure in Figure 1b. By overgrowing the electrode metal contact 180 the leakage risk from any underlying later is reduced. The cathode metal contacts 180a may extend to a surrounding n-type layer, such as any of the first layers 120, over parts of masking layers 140, as illustrated in Figure 1b. The contact with an n-type layer may also be obtained in another aperture 142 than the one comprising the microstructure to be contacted. The anode metal contacts 180b are only in contact with any of the p-type layers or insulation layers, such as the second semiconductor layer 164.

The formation of anode and cathode contacts on the epi surface side 102 of the substrate 100 of the LED array precursor 10, as also in the case for the present invention as claimed, enables a flip-chip integration of the LED array precursor 10. Meaning that the LED array precursor 10 is directly attached to the secondary circuits of the backplane 20 by means of the electrically conductive metal bumps 240. This is advantageous as the connection paths becomes shorter compared to the design with electrical contacts on the side opposite to the epi surface side 102. Thereby the speed of the circuit is improved. Further, the LED array precursor 10 has a smaller form factor as no electrical contacts are placed on the side opposite to the epi surface side 102. When forming the electrode metal contact 180 on parts of the microstructures 160, the number of different elements and the number of processing steps can be reduced.

The previously described embodiment may also be based on a p-type first semiconductor layer 120b. In that case also the microstructures 160 may be p-type and the second semiconductor layer 164 may be n-type. The materials and doping levels mentioned previously for the respective n- and p-type materials may be used. The electronic contacts formed by the electrode metal contact 180 are reversed, respectively.

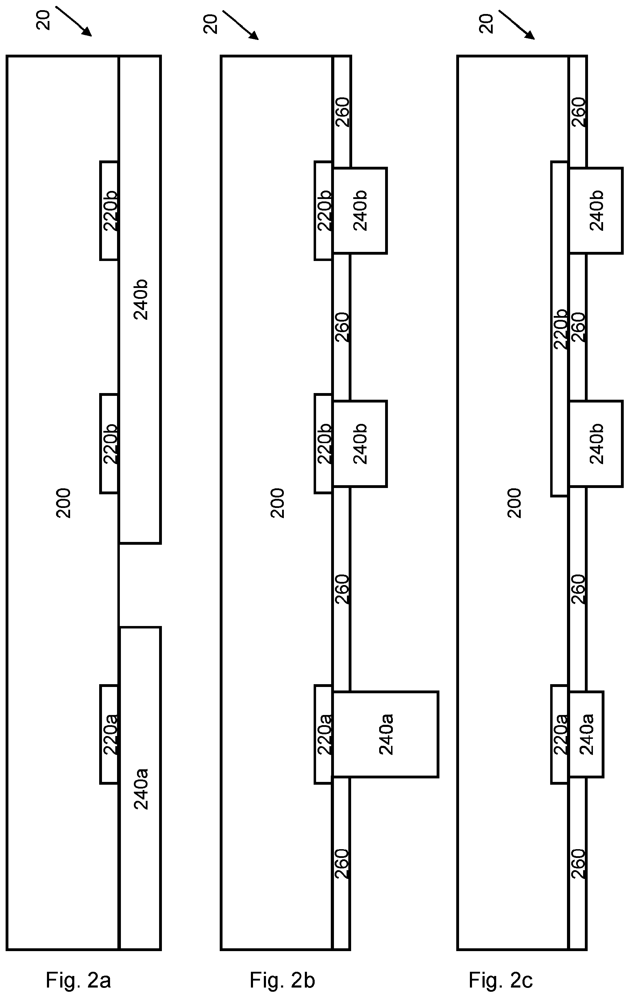

Figure 2a-c schematically illustrates a LED backplane 20, such as involved in the present invention as claimed. The backplane 20 comprises a backplane substrate 200, backplane electrode bonding pads 220, and metal bumps 240. Preferably, the backplane substrate 200 is made of Si. The substrate may be electrically insulating or may be covered with an additional layer that is electrically insulating such as insulator 260. The insulator 260 may be made of SiO2 or Si3N4. The backplane electrode bonding pads 220, supported on the backplane support 200, may be made of In, Cu or Al. The electrode bonding pads may be cathode bonding pads 220a or anode bonding pads 220b. The electrode bonding pads 220 are in electrical contact with the metal bump 240. The metal bump 240 may be metal bump that connects to a cathode 240a or an anode 240b, respectively. The metal bumps 240 may be of different materials for the anode and the cathode. Preferably, the metal bumps 240 are made of Cu, In, Au.

There are different configurations for the secondary electrical contact of the backplane 20. In Figure 2a the backplane electrode bonding pads 220 can be connected to a single metal bump 240 or one or more metal bumps 240 of the same type. This allows for the addressing of single or multiple LED structures in the corresponding LED array precursor 10. The different metal bumps 240 of the backplane 20 are separated by gaps between the different metal bumps 240 and thereby they are not in electrical contact with each other. In the example of Figure 2b, each backplane electrode bonding pads 220 has a corresponding metal contact 240. The height of the metal bumps 240 may vary to compensate for different heights of the underlying structure on the LED array precursor 10 that the backplane 20 is intended to be connected to. The gaps between the metal bumps 240 are filled with an insulation layer 260. The insulator 260 may be made of SiO₂ or Si₃N₄. A single backplane electrode bonding pad 220 may also connect to one or more metal contact 240, as shown in Figure 2c. The different features of the embodiments illustrated in Figures 2a-c may be freely combined with each other and with any other embodiment disclosed herein.

Figure 3 schematically illustrates a cross section through a LED array precursor 10 with electrode metal contacts 180 that are different for the cathode and anode metal contact 180a and 180b, respectively. Their formation requires the deposition of one or more further masking layers 140a. The further masking layers may at least partially cover the microstructures 160 and/or any of the layers covering the same. The further masking layers may be of the same material and thickness as the masking layer 140. By removing parts of the further masking layer 140a, apertures 142a are generated. The size of the apertures 142a may vary for the different LED structures which should be contacted. The apertures 142a may also cover certain facets or sides of the underlying microstructure 160. To deposit one or more different kinds of electrode metal contact 180, additional masking layers 140a with each exhibiting different patterns may be applied. Optionally, at least parts of the excess electrode metal contact material 180 may be selectively removed. Additional masking layers 140a may be deposited after creating the electrode metal contacts 180 for improving light extraction properties of the LED structure.

The determination whether a microstructure 160, which may be covered by an active layer 162 and/or a second semiconductor layer 164, serves as anode or cathode depends on the positioning of the electrode metal contact 180. In the case where the electrode metal contact 180 at least partially connects to n-doped parts within the LED array precursor, the electrode metal contact 180 serves as a cathode metal contact. The case where the electrode metal contact 180 at least partially connects to p-doped parts within the LED array precursor, the electrode metal contact 180 serves as an anode metal contact 180b. The electrode metal contact may also extend over insulating parts of the LED array precursor such as the masking layers 140 and further masking layers 140a. The electrode metal contacts 180 may extend over more than a single LED and thereby group several LEDs into an associated circuit making them addressable as a group.

Figure 4 schematically illustrates a cross section though a LED array precursor 10 in electrical contact with the backplane 20, for example as in the present invention as claimed. This is achieved by at least bonding part of the electrical metal contacts 180 of the LED array precursor 10 chemically, physically and/or mechanically with corresponding bonding pad 220 of the backplane 20 via the metal contact 240. Thereby electrical contact between primary electrical contacts, i.e. the cathode and anode contacts 180a, 180b, respectively, of the LED array precursor 10, and the opposing secondary electrical contacts of the backplane 20 are established, which allows to drive the light emission by the LED structures through associated circuits. Sharp connection points between the LED structure and the metal contact 240 of the backplane 20 are advantageous as they reduce connection problems in hybridization. Therefore, microstructures 160 that allow for such a connection are preferred.

Further, Figure 4 shows an embodiment where the substrate 100 of the LED array precursor 10 has been removed from the first layers 120. This is required for any non-transparent materials of substrate 100. Thereby light emission from the electrically insulated LED structures each comprising microstructures 160 and active layers 162 is facilitated in the direction 400. Optionally, only parts of the substrate 100 may be removed. This may be done selectively for areas with underlying LED structures selected for light emission. Further, buffer layers 120a may be removed at least partially. A new additional layer may be adhered to the first layers 120 to provide a surface with improved light extraction properties. Such a layer may comprise SiC, sapphire, Si, GaN, GaN on Si, GaN on sapphire, GaN, AIN, InN and their ternary and quaternary compounds. The layer may be roughened. The substrate 100 and/or parts of the first layers 120 may be removed before or after contacting the backplane.

Figure 5 schematically illustrates a cross section though a LED array precursor 10 in electrical contact with the backplane 20 with a filler material 300 between the LED array precursor 10 and the backplane 20. The filler material 300 may be an epoxy, glue, solder, or flux or other well-known material in the art which are preferably electrically insulating, flexible, have a low thermal expansion coefficient and no outgassing. The filler material 300 may be hydrogen silsesquioxane (HSQ). The filler material 300 may be applied though capillary flow or molded. The filler material 300 may be applied before the substrate 100 of the LED array precursor is removed.

Figures 6a-i schematically illustrate cross sections of different examples of microstructures 160 which may be used in a LED array precursor 10. Figures 6a to 6d illustrate a triangular cross section, a trapezoidal cross section with the base smaller than the apex, a trapezoidal cross section with the base larger than the apex, and a rectangular cross section, respectively. Figures 6e to 6i illustrate preferred combinations of the previously mentioned cross sections into more advanced structures. Figures 6e to 6i show a trapezoidal cross section with the base larger than the apex as bottom structure connected with a rectangular cross section added on top of the bottom structures apex, a rectangular cross section has bottom structure with a trapezoidal cross section on top of the bottom structures apex with the base of the trapezoidal cross section being wider than the apex of the rectangular bottom structure, a rectangular cross section as bottom structure with a triangular cross section on top of the bottom structure's apex, a rectangular cross section as bottom structure with a triangular cross section on top of the bottom structure's apex with the base of the triangular cross section being wider than the apex of the rectangular bottom structure, and a trapezoidal cross section with the base larger than the apex as bottom structure connected with a rectangular cross section as middle structure added on top of the bottom structures apex and a triangular cross section added on top of the middle structure, respectively. The height of the microstructures 160 may range from a few monolayers to several microns. The angle α may range from 0° to 90°, preferably they are between 50° and 70°, most preferably between 60° and 65°.

Figures 7a-h schematically illustrate top views of different examples of microstructures 160 used may be used in a LED array precursor 10. Figures 7a to 7e show a circular base, a quadratic base, a rectangular base, a regular hexagonal base, and an elongated hexagonal base, respectively. Figures 7f to 7h illustrate embodiments where the base is larger that the apex. Figure 7f illustrates a hexagonal base with an apex which is also hexagonal but smaller in diameter. Figure 7g illustrates an embodiment with a hexagonal base and a smaller circular apex. Figure 7h illustrates an embodiment with an elongated hexagonal base and a smaller elongated hexagonal apex.

Any of the previously disclosed cross sections may be combined with the bases and/or base and apex combinations as described above to obtain the three-dimensional microstructures 160. Preferred examples of the microstructures 160 are pyramids, symmetric pyramids, elongated pyramids, truncated pyramids, platelets, nanowires, nanowires with a pyramidal top or a combination thereof. The different three-dimensional microstructures may be obtained by SAG or through etching of grown structures or a combination thereof. An example of a preferred microstructure 160 is described in SE537434C2.

Figures 8a-f illustrate a top view on the LED array precursor 10 and the different embodiments of how the apertures 142 comprising the LED structures are spaced across the LED array precursor 10. They may be packed in different regular patterns, which resemble any configuration for the close-packing of circles, such as square packing or hexagonal packing. In Figures 8a, d, e the apertures' 142 distribution is based on a rectangular packing pattern. In Figures 8b and c a hexagonal packing pattern is exemplified. Other patterns may include wavy, or bent rows as illustrated in Figure 8f. The overall pattern of the LED array precursor 10 may be a combination of several patterns and they may be discontinuous throughout the entire LED array precursor 10.

Independent of the pattern of the apertures 142 comprising the LED structures on the precursors 10, the LED structures may be contacted in different arrays and subarrays by contacting with a common electrode contact material 180. Grouping of the single LEDs into arrays may be based on different parameters such as dominant wavelength and/or polarization of the light emitted for the LED structures. Figures 8a, b illustrate grouping several rows and columns of LED structures into an array for configuration based on square and hexagonal packing, respectively. As only an excerpt of the entire LED array precursor 10 is shown, the precursor may comprise several of the illustrated arrays.

Figure 8c illustrates subarrays which are created by grouping single rows of LED structures together with an underlying hexagonal packing of apertures 142. Further, the contacting of individual LED structures is illustrated in Figure 8c. Figure 8d exemplifies grouping of LED structures in differently sized subarrays for an underlying square packing of apertures 142. The grouping motive in Figure 8e illustrates that single rows and/or columns of LED structures may not be contacted at all. Figures 8f illustrates the grouping of LED structures for waved and bend patterns of LED structures.

The different packaging and contacting patterns may be used to compensate for optical aberrations that can occur when integrating the LED array in a device. Thereby the system complexity is reduced, which is advantageous for manufacturing smaller and more light-weight devices. Especially for applications which comprise bent light extraction or projection surfaces, a positioning in wavy or bend or otherwise distorted patterns may be of advantage.

As used herein, the expression "may" and "in some embodiments" has typically been used to indicate that the features described may be combined with any other embodiment disclosed herein.

When using the word "comprise" or "comprising" it shall be interpreted as nonlimiting, i.e. meaning "consist at least of".

The embodiments herein are not limited to the above described embodiments. Various alternatives and modifications may be used. Therefore, the above embodiments should not be taken as limiting the scope of the present invention, which is defined by the following claims.

## Claims

1. A method of forming a light-emitting diode (LED) array, the method comprising forming a LED array precursor (10) by:
(i) providing a substrate (100);
(ii) forming one or more first layers (120) on an epi surface side (102) of the substrate (100), wherein the one or more first layers (120) at least comprise a first semiconductor layer (120b) and wherein further one or more first layers (120), if any, further comprise buffer layers (120a) stacked between the substrate (100) and the first semiconductor layer (120b);
(iii) selectively masking said one or more first layers (120) by thereon depositing one or more masking layers (140) wherein unmask portions of said one or more first layers (120) form a plurality of apertures (142);
(iv) forming microstructures (160) within at least part of the plurality of apertures (142), wherein the microstructures (160) are in physical contact with the first semiconductor layer (120b);
(v) forming one or more active layers (162) at least partly covering the microstructures (160);
(vi) forming a second semiconductor layer (164) at least partly covering the microstructures (160) and/or the one or more active layers (162);
(vii) forming both anode and cathode electrical contacts (180a, b) of same or different electrical contact material on the epi surface side (102) of the substrate (100); and the method further comprising
(viii) forming electrical contact between at least part of the anode and cathode electrical contacts (180a, b) of the LED array precursor (10) with a backplane (20) by bonding the electrical contact material of the anode and cathode electrical contacts (180a, 180b), chemically, physically and/or mechanically, with corresponding metal bumps (240a, 240b) of corresponding bonding pads (220a, 220b) of the backplane (20) and thereby bringing both the anode and cathode contacts (180a, b) in electrical contact with secondary electrical contacts of the backplane (20).

2. The method according to claim 1, wherein the step (vii) for forming both anode and cathode electrical contacts (180a, b) on the epi surface side (102) of the substrate (100) comprises:
(vii.i) depositing one or more further masking layers (140a) on the epi surface side (102);
(vii.ii) patterning said further masking layer (140a) by selectively removing a plurality of portions of said further masking layer (140a) to create further apertures (142a), wherein at least part of the further apertures (142a) comprise microstructures (160) which were formed under step (iv) in claim 1;
(vii.iii) depositing said electrode contact material of the anode and cathode electrical contacts (180a, 180b) onto the patterned masking layer (140a);
(vii.iv) optionally removing at least parts of the excess electrode contact material (180) and/or masking layer (140a).

3. The method according to any of the preceding claims, wherein the substrate (100) is made of a material selected from the group consisting of SiC, sapphire, Si, GaN, GaN on Si, GaN on sapphire, SiO₂, graphene.

4. The method according to any of the preceding claims, wherein the material of the first and second semiconductor layers (120b, 164), the microstructures (160) and the active layers (162) comprise group III-nitrides.

5. The method according to any of the preceding claims, wherein the buffer layers (120a) are selected from the group consisting of SiC, sapphire, Si, GaN, GaN on Si, GaN on sapphire, GaN, AIN, InN and their ternary and quaternary compounds.

6. The method according to any of the preceding claims, wherein the microstructures (160) are one or more of the following: pyramids, symmetric pyramids, elongated pyramids, truncated pyramids, platelets, nanowires, nanowires with a pyramidal top, etched structures or any combination thereof.

7. The method according to any of the preceding claims, wherein the active layer (162) comprises one or more quantum structures, such as quantum wells, quantum dots, quantum wires or a combination thereof.

8. The method according to claim 7, wherein the quantum structure comprises GaN, AIN, InN and/or their ternary and quaternary compounds.

9. The method according to any of the preceding claims, wherein the method further comprises a step of at least partially removing the substrate (100) or partially removing the substrate (100) and the first layers (120) from the LED array precursor (10).

10. The method according to any of the preceding claims, wherein the method further comprises a step of filling the gap between the LED array precursor (10) and the backplane (20) with a filler material (300).

11. A LED array comprising:
a LED array precursor (10) and a backplane (20),
wherein the LED array precursor (10) comprises:
(i) one or more first layers (120), wherein the first layers comprise at least a first semiconductor layer (120b) and wherein further one or more first layers, if any, are buffer layers (120a);
(ii) a masking layer (140) at least partially covering said one or more first layers (120), wherein the masking layer (140) comprises a plurality of apertures (142);
(iii) microstructures (160) on and in physical contact with said first semiconductor layer (120b) within at least parts of the apertures (142) of the masking layer (140);
(iv) one or more active layers (162) at least partly covering the microstructures (160);
(v) a second semiconductor layer (164) at least partly covering the microstructures (160) and/or the active layer (162),
(vi) both anode and cathode electrical contacts (180a, b) of same or different electrical contact material, wherein both the anode and the cathode electrical contacts (180a, b) are provided on an epi surface side (102), and
wherein the backplane (20) comprises:
a backplane substrate (200), bonding pads (220a, 220b) of the backplane substrate (200), and metal bumps (240a, 240b) on and in electrical contact with the bonding pads (220a, 220b), and
wherein electrical contact between at least part of the anode and cathode electrical contacts (180a, b) of the LED array precursor (10) and the backplane (20) is provided by a chemical, physical and/or mechanical bond between said electrical contact material of the anode and cathode electrical contacts (180a, 180b) and said metal bumps (240a, 240b).

12. The LED array according to claim 11, wherein the metal bumps are made of indium (In), copper (Cu) or gold (Au).

13. The LED array according to claim 11 or 12, wherein the LED array precursor (10) comprises a substrate (100) provided with the items (i), (ii), (iii), (iv), (v) and (vi) on its epi surface side (102).

14. The LED array of any of the claims 11-13, wherein both the anode and cathode electrical contacts (180a, b) of item (vi) on the epi surface side (102) are formed in at least parts of further apertures (142a) formed in a further masking layer (140a), wherein at least part of the further apertures (142a) comprise microstructures (160) of item (iii).

15. A display device, a communication device, an optoelectronic device, an interconnect device, a cryptography device, a lighting device or illumination device comprising the LED array according to any of the claims 11-14.

## Patentansprüche

1. Ein Verfahren zum Bilden eines lichtemittierenden Dioden-(LED-)Arrays, wobei das Verfahren das Bilden eines LED-Array-Vorläufers (10) umfasst durch:
(i) das Bereitstellen eines Substrats (100);
(ii) das Bilden einer oder mehrerer erster Schichten (120) auf einer Epi-Oberflächenseite (102) des Substrats (100), wobei die eine oder mehreren ersten Schichten (120) zumindest eine erste Halbleiterschicht (120b) umfassen und wobei weitere, gegebenenfalls vorhandene erste Schichten (120) Pufferschichten (120a) umfassen, die zwischen dem Substrat (100) und der ersten Halbleiterschicht (120b) geschichtet sind;
(iii) das selektive Maskieren der einen oder mehreren ersten Schichten (120) durch Aufbringen einer oder mehrerer Maskierungsschichten (140), wobei unmaskierte Bereiche der einen oder mehreren ersten Schichten (120) eine Vielzahl von Öffnungen (142) bilden;
(iv) das Bilden von Mikrostrukturen (160) innerhalb zumindest eines Teils der Vielzahl von Öffnungen (142), wobei die Mikrostrukturen (160) in physikalischem Kontakt mit der ersten Halbleiterschicht (120b) stehen;
(v) Bilden einer oder mehrerer aktiver Schichten (162), die die Mikrostrukturen (160) zumindest teilweise bedecken;
(vi) Bilden einer zweiten Halbleiterschicht (164), die die Mikrostrukturen (160) und/oder die eine oder mehreren aktiven Schichten (162) zumindest teilweise bedeckt;
(vii)Bilden sowohl von Anoden- als auch Kathoden-Kontaktstrukturen (180a, 180b) aus gleichem oder unterschiedlichem Kontaktwerkstoff auf der Epi-Oberflächenseite (102) des Substrats (100);
und das Verfahren umfasst ferner:
(viii) Herstellen eines elektrischen Kontakts zwischen zumindest einem Teil der Anoden- und Kathoden-Kontaktstrukturen (180a, 180b) des LED-Array-Vorläufers (10) und einer Rückwandplatine (20) durch Verbinden des Kontaktwerkstoff der Anoden- und Kathoden-Kontaktstrukturen (180a, 180b) chemisch, physikalisch und/oder mechanisch mit entsprechenden Metallbumps (240a, 240b) entsprechender Bondpads (220a, 220b) der Rückwandplatineplatine (20), wodurch sowohl die Anoden- als auch die Kathodenkontakte (180a, 180b) in elektrischen Kontakt mit sekundären elektrischen Kontakten der Rückwandplatineplatine (20) gebracht werden.

2. Verfahren nach Anspruch 1, wobei Schritt (vii) zum Bilden sowohl der Anoden- als auch der Kathoden-Kontaktstrukturen (180a, 180b) auf der Epi-Oberflächenseite (102) des Substrats (100) umfasst:
(vii.i) Aufbringen einer oder mehrerer weiterer Maskierungsschichten (140a) auf die Epi-Oberflächenseite (102);
(vii.ii) Strukturieren der weiteren Maskierungsschicht (140a) durch selektives Entfernen einer Vielzahl von Bereichen der weiteren Maskierungsschicht (140a), um weitere Öffnungen (142a) zu erzeugen, wobei zumindest ein Teil der weiteren Öffnungen (142a) Mikrostrukturen (160) umfasst, die gemäß Schritt (iv) in Anspruch 1 gebildet wurden;
(vii.iii) Abscheiden eines Elektrodenkontaktwerkstoffs der Anoden- und Kathoden-Kontaktstrukturen (180a, 180b) auf die strukturierte Maskierungsschicht (140a);
(vii.iv) optionales Entfernen zumindest von Teilen des überschüssigen Elektrodenkontaktwerkstoffs (180) und/oder der Maskierungsschicht (140a).

3. Verfahren nach einem der vorhergehenden Ansprüche, wobei das Substrat (100) aus einem Material ausgewählt aus der Gruppe bestehend aus: SiC, Saphir, Si, GaN, GaN auf Si, GaN auf Saphir, SiO₂, Graphen.

4. Verfahren nach einem der vorhergehenden Ansprüche, wobei das Material der ersten und zweiten Halbleiterschichten (120b, 164), der Mikrostrukturen (160) und der aktiven Schichten (162) III-Nitrid-Halbleiter umfasst.

5. Verfahren nach einem der vorhergehenden Ansprüche, wobei die Pufferschichten (120a) aus der Gruppe ausgewählt sind, bestehend aus: SiC, Saphir, Si, GaN, GaN auf Si, GaN auf Saphir, GaN, AIN, InN sowie deren ternären und quaternären Verbindungen.

6. Verfahren nach einem der vorhergehenden Ansprüche, wobei die Mikrostrukturen (160) eine oder mehrere der folgenden Formen aufweisen: Pyramiden, symmetrische Pyramiden, gestreckte Pyramiden, gestutzte Pyramiden, Plättchen, Nanodrähte, Nanodrähte mit pyramidenförmiger Oberseite, geätzte Strukturen oder Kombinationen davon.

7. Verfahren nach einem der vorhergehenden Ansprüche, wobei die aktive Schicht (162) eine oder mehrere Quantenstrukturen umfasst, wie Quantentopf, Quantenpunkte, Quantendrähte oder Kombinationen davon.

8. Verfahren nach Anspruch 7, wobei die Quantenstruktur GaN, AIN, InN und/oder deren ternäre und quaternäre Verbindungen umfasst.

9. Verfahren nach einem der vorhergehenden Ansprüche, wobei das Verfahren ferner einen Schritt des zumindest teilweisen Entfernens des Substrats (100) oder des teilweisen Entfernens des Substrats (100) und der ersten Schichten (120) vom LED-Array-Vorläufer (10) umfasst.

10. Verfahren nach einem der vorhergehenden Ansprüche, wobei das Verfahren ferner einen Schritt umfasst, bei dem der Spalt zwischen dem LED-Array-Vorläufer (10) und der Rückwandplatine (20) mit einem Füllmaterial (300) gefüllt wird.

11. Ein LED-Array umfassend:
einen LED-Array-Vorläufer (10) und eine Rückwandplatine (20),
wobei der LED-Array-Vorläufer (10) umfasst:
(i) eine oder mehrere erste Schichten (120), wobei die ersten Schichten zumindest eine erste Halbleiterschicht (120b) umfassen und weitere, gegebenenfalls vorhandene erste Schichten Pufferschichten (120a) sind;
(ii) eine Maskierungsschicht (140), die die einen oder mehreren ersten Schichten (120) zumindest teilweise bedeckt, wobei die Maskierungsschicht (140) eine Vielzahl von Öffnungen (142) umfasst;
(iii) Mikrostrukturen (160) auf und in physikalischem Kontakt mit der ersten Halbleiterschicht (120b) innerhalb zumindest eines Teils der Öffnungen (142);
(iv) eine oder mehrere aktive Schichten (162), die die Mikrostrukturen (160) zumindest teilweise bedecken;
(v) eine zweite Halbleiterschicht (164), die die Mikrostrukturen (160) und/oder die aktive Schicht (162) zumindest teilweise bedeckt;
(vi) sowohl Anoden- als auch Kathoden-Kontaktstrukturen (180a, 180b) aus gleichem oder unterschiedlichem Kontaktwerkstoff, wobei sowohl die Anoden- als auch die Kathodenkontaktstrukturen (180a, 180b) auf der Epi-Oberflächenseite (102) gegeben sind; und
wobei die Rückwandplatine (20) umfasst:
ein Rückwandplatinesubstrat (200), Bondpads (220a, 220b) des Rückwandplatinesubstrats (200) und Metallbumps (240a, 240b), die sich auf den Bondpads befinden und in elektrischem Kontakt mit diesen stehen,
wobei ein elektrischer Kontakt zwischen zumindest einem Teil der Anoden- und Kathodenkontaktstrukturen (180a, 180b) des LED-Array-Vorläufers (10) und der Rückwandplatine (20) durch eine chemische, physikalische und/oder mechanische Verbindung zwischen dem Kontaktwerkstoff der Anoden- und Kathodenkontaktstrukturen (180a, 180b) und den Metallbumps (240a, 240b) bereitgestellt wird.

12. LED-Array nach Anspruch 11, wobei die Metallbumps aus Indium (In), Kupfer (Cu) oder Gold (Au) bestehen.

13. LED-Array nach Anspruch 11 oder 12, wobei der LED-Array-Vorläufer (10) ein Substrat (100) umfasst, welches die Gegenstände (i), (ii), (iii), (iv), (v) und (vi) auf seiner Epi-Oberflächenseite (102) trägt.

14. LED-Array nach einem der Ansprüche 11-13, wobei sowohl die Anoden- als auch die Kathodenkontaktstrukturen (180a, 180b) gemäß Gegenstand (vi) auf der Epi-Oberflächenseite (102) zumindest in Teilen der weiteren Öffnungen (142a) gebildet sind, die in der weiteren Maskierungsschicht (140a) gebildet wurden, wobei zumindest ein Teil der weiteren Öffnungen (142a) Mikrostrukturen (160) gemäß Gegenstand (iii) umfasst.

15. Bildschirmgegerät, Kommunikationsgerät, optoelektronisches Gerät, Datenverbindungselement, kryptographisches Gerät, Beleuchtungsgerät oder Illuminationseinrichtung, umfassend das LED-Array gemäß einem der Ansprüche 11 bis 14.

## Revendications

1. Procédé de formation d'un réseau de diodes électroluminescentes (DEL), le procédé comprenant la formation d'un précurseur de réseau de DEL (10) :
(i) par fourniture d'un substrat (100) ;
(ii) par formation d'au moins une première couche (120) sur un côté de surface épitaxiale (102) du substrat (100), dans lequel l'au moins une première couche (120) comprend au moins une première couche semi-conductrice (120b) et dans lequel une ou plusieurs autres premières couches (120), le cas échéant, comprennent en outre des couches tampons (120a) empilées entre le substrat (100) et la première couche semi-conductrice (120b) ;
(iii) par masquage sélectif desdites une ou plusieurs premières couches (120) par dépôt sur celles-ci d'au moins une couche de masquage (140), les parties non masquées desdites une ou plusieurs premières couches (120) formant une pluralité d'ouvertures (142) ;
(iv) par formation des microstructures (160) dans au moins une partie de la pluralité d'ouvertures (142), les microstructures (160) étant en contact physique avec la première couche semi-conductrice (120b) ;
(v) par formation d'une ou de plusieurs couches actives (162) recouvrant au moins partiellement les microstructures (160) ;
(vi) par formation d'une seconde couche semi-conductrice (164) recouvrant au moins partiellement les microstructures (160) et/ou la ou les couches actives (162) ;
(vii) par formation deux contacts électriques (180a, b) d'anode et de cathode conçus à partir d'une matière de contact électrique identique ou différente sur le côté de surface épitaxiale (102) du substrat (100) ; et le procédé comprenant en outre
(viii) la formation d'un contact électrique entre au moins une partie des contacts électriques (180a, b) d'anode et de cathode du précurseur d'un réseau de DEL (10) comportant un fond de panier (20) par liaison de la matière de contact électrique des contacts électriques (180a, 180b) d'anode et de cathode, chimiquement, physiquement et/ou mécaniquement, avec des bosses métalliques (240a, 240b) correspondantes des plots de liaison (220a, 220b) correspondants du fond de panier (20) et ainsi par mise en contact électrique des deux contacts (180a, b) d'anode et de cathode avec les contacts électriques secondaires du fond de panier (20).

2. Procédé selon la revendication 1, dans lequel l'étape (vii) de formation des deux contacts électriques (180a, b) d'anode et de cathode sur le côté de surface épitaxiale (102) du substrat (100) comprend :
(vii.i) le dépôt d'une ou de plusieurs couches de masquage (140a) sur le côté de surface épitaxiale (102) ;
(vii.ii) la structuration de ladite autre couche de masquage (140a) par suppression sélective d'une pluralité de parties de ladite autre couche de masquage (140a) pour créer d'autres ouvertures (142a), dans lequel au moins une partie des autres ouvertures (142a) comprend des microstructures (160), lesquelles ont été formées à l'étape (iv) de la revendication 1 ;
(vii.iii) le dépôt de ladite matière de contact d'électrode des contacts électriques (180a, 180b) d'anode et de cathode sur la couche de masquage (140a) structurée ;
(vii.iv) la suppression, éventuellement, dau moins certaines parties de la matière de contact (180) d'électrode excédentaire et/ou de la couche de masquage (140a).

3. Procédé selon l'une quelconque des revendications précédentes, dans lequel le substrat (100) est conçu d'une matière choisie dans le groupe constitué du SiC, le saphir, du Si, du GaN, du GaN sur Si, du GaN sur saphir, du SiO₂ et du graphène.

4. Procédé selon l'une quelconque des revendications précédentes, dans lequel la matière des première et seconde couches semi-conductrices (120b, 164), des microstructures (160) et des couches actives (162) comprend des nitrures du groupe III.

5. Procédé selon l'une quelconque des revendications précédentes, dans lequel les couches tampons (120a) sont choisies dans le groupe constitué du SiC, du saphir, du Si, du GaN, du GaN sur Si, du GaN sur saphir, de l'AIN, de l'InN et de leurs composés ternaires et quaternaires.

6. Procédé selon l'une quelconque des revendications précédentes, dans lequel les microstructures (160) sont au moins l'une des suivantes : pyramides et/ou pyramides symétriques et/ou de pyramides allongées et/ou pyramides tronquées et/ou plaquettes et/ou nanofils et/ou nanofils à sommet pyramidal et/ou structures gravées et/ou n'importe laquelle de leurs combinaisons.

7. Procédé selon l'une quelconque des revendications précédentes, dans lequel la couche active (162) comprend une ou plusieurs structures quantiques telles que des puits quantiques et/ou des points quantiques et/ou des fils quantiques et/ou leur combinaisons.

8. Procédé selon la revendication 7, dans lequel la structure quantique comprend le GaN, l'AIN, l'InN et/ou leurs composés ternaires et quaternaires.

9. Procédé selon l'une quelconque des revendications précédentes, le procédé comprenant en outre une étape de retrait au moins partiel du substrat (100) ou de retrait partiel du substrat (100) et des premières couches (120) du précurseur de réseau de DEL (10).

10. Procédé selon l'une quelconque des revendications précédentes, le procédé comprenant en outre une étape de remplissage de l'espace entre le précurseur de réseau de DEL (10) et le fond de panier (20) avec une matière de remplissage (300).

11. Réseau de DEL comprenant :
un précurseur de réseau de DEL (10) et un fond de panier (20),
dans lequel le précurseur de réseau de DEL (10) comprend :
(i) une ou plusieurs premières couches (120), les premières couches comprenant au moins une première couche semi-conductrice (120b) et une ou plusieurs autres premières couches, le cas échéant, étant des couches tampons (120a) ;
(ii) une couche de masquage (140) recouvrant au moins partiellement lesdites une ou plusieurs premières couches (120), la couche de masquage (140) comprenant une pluralité d'ouvertures (142) ;
(iii) des microstructures (160) sur ladite première couche semi-conductrice (120b) et en contact physique avec celle-ci dans au moins certaines parties des ouvertures (142) de la couche de masquage (140) ;
(iv) une ou plusieurs couches actives (162) recouvrant au moins partiellement les microstructures (160) ;
(v) une seconde couche semi-conductrice (164) recouvrant au moins partiellement les microstructures (160) et/ou la couche active (162),
(vi) les deux contacts électriques (180a, b) d'anode et de cathode sont conçus d'une matière de contact électrique identique ou différente, les deux contacts électriques (180a, b) d'anode et de cathode étant situés sur un côté de surface épitaxiale (102), et
dans lequel le fond de panier (20) comprend :
un substrat de fond de panier (200), des plots de connexion (220a, 220b) du substrat de fond de panier (200), et des bosses métalliques (240a, 240b) sur les plots de connexion (220a, 220b) et en contact électrique avec ceux-ci, et dans lequel le contact électrique entre au moins une partie des contacts électriques (180a, b) d'anode et de cathode du précurseur de réseau de DEL (10) et le fond de panier (20) est fourni à l'aide d'une liaison chimique, physique et/ou mécanique entre ladite matière de contact électrique des contacts électriques (180a, 180b) d'anode et de cathode et lesdites bosses métalliques (240a, 240b).

12. Réseau de DEL selon la revendication 11, dans lequel les bosses métalliques sont conçues en indium (In), en cuivre (Cu) ou en or (Au).

13. Réseau de DEL selon la revendication 11 ou 12, dans lequel le précurseur de réseau de DEL (10) comprend un substrat (100) doté des éléments (i), (ii), (iii), (iv), (v) et (vi) sur son côté de surface épitaxiale (102).

14. Réseau de DEL selon l'une quelconque des revendications 11 à 13, dans lequel les deux contacts électriques (180a, b) d'anode et de cathode de l'élément (vi) sur le côté de surface épitaxiale (102) sont formés dans au moins certaines parties des autres ouvertures (142a) formées dans une autre couche de masquage (140a), au moins une partie des autres ouvertures (142a) comprenant des microstructures (160) de l'élément (iii).

15. Dispositif d'affichage, dispositif de communication, dispositif optoélectronique, dispositif d'interconnexion, dispositif de cryptographie, dispositif d'éclairage ou dispositif d'illumination comprenant le réseau de DEL selon l'une quelconque des revendications 11 à 14.
